(19) Europäisches Patentamt
European Patent Office
Office européen des brevets

(11) **EP 1 797 602 B1**

(12) **EUROPÄISCHE PATENTSCHRIFT**

(45) Veröffentlichungstag und Bekanntmachung des Hinweises auf die Patenterteilung:
**07.05.2008 Patentblatt 2008/19**

(21) Anmeldenummer: **05796983.4**

(22) Anmeldetag: **27.09.2005**

(51) Int Cl.:
***H01L 39/16*** *(2006.01)*       *H02H 9/02* *(2006.01)*

(86) Internationale Anmeldenummer:
**PCT/EP2005/054856**

(87) Internationale Veröffentlichungsnummer:
**WO 2006/037743 (13.04.2006 Gazette 2006/15)**

(54) **RESISTIVE STROMBEGRENZEREINRICHTUNG MIT BANDFÖRMIGER HOCH-TC-SUPRALEITERBAHN**

RESISTIVE CURRENT-LIMITING DEVICE PROVIDED WITH A STRIP-SHAPED HIGH-TC-SUPER CONDUCTOR PATH

DISPOSITIF RESISTIF DE LIMITATION DE COURANT POURVU D'UNE PISTE SUPRACONDUCTRICE EN FORME DE BANDE A HAUTE TC

(84) Benannte Vertragsstaaten:
**AT BE BG CH CY CZ DE DK EE ES FI FR GB GR HU IE IS IT LI LT LU LV MC NL PL PT RO SE SI SK TR**

(30) Priorität: **04.10.2004 DE 102004048647**

(43) Veröffentlichungstag der Anmeldung:
**20.06.2007 Patentblatt 2007/25**

(73) Patentinhaber: **SIEMENS AKTIENGESELLSCHAFT 80333 München (DE)**

(72) Erfinder:
• **KRÄMER, Hans-Peter 91058 Erlangen (DE)**
• **SCHMIDT, Wolfgang 91056 Erlangen (DE)**

(56) Entgegenhaltungen:
**WO-A-99/33122       DE-A1- 10 226 391
DE-C1- 4 434 819**

**Beschreibung**

Die Erfindung bezieht sich auf eine resistive supraleitende Strombegrenzereinrichtung, deren Leiterbahn mit einem bandförmigen Supraleiter gebildet ist, dessen oxidisches Hoch-$T_c$-Supraleitermaterial vom Typ $AB_2Cu_3O_x$ ist, wobei A zumindest ein Seltenes Erdmetall einschließlich Yttrium und B mindestens ein Erdalkalimetall sind. Eine entsprechende Strombegrenzereinrichtung geht aus der EP 0 523 374 A1 hervor.

Seit 1986 sind supraleitende Metalloxidverbindungen mit hohen Sprungtemperaturen $T_c$ von über 77 K bekannt, die deshalb auch als Hoch-$T_c$-Supraleitermaterialien oder HTS-Materialien bezeichnet werden und insbesondere eine Flüssig-Stickstoff (LN$_2$)-Kühltechnik erlauben. Unter solche Metalloxidverbindungen fallen insbesondere Cuprate auf Basis spezieller Stoffsysteme wie z.B. vom Typ $AB_2Cu_3O_x$, wobei A zumindest ein Seltenes Erdmetall einschließlich Yttrium und B mindestens ein Erdalkalimetall sind. Hauptvertreter dieses Stoffsystems vom sogenannten 1-2-3-HTS-Typ ist das sogenannte YBCO ($Y_1Ba_2Cu_3O_x$ mit $6{,}5 \leq x \leq 7$).

Dieses bekannte HTS-Material versucht man, auf verschiedenen Substraten für unterschiedliche Anwendungszwecke abzuscheiden, wobei im Allgemeinen nach möglichst phasenreinem Supraleitermaterial getrachtet wird. So werden insbesondere metallische Substrate für Leiteranwendungen vorgesehen (vgl. z.B. EP 0 292 959 A1).

Bei einem entsprechenden Leiteraufbau wird das HTS-Material im Allgemeinen nicht unmittelbar auf einem als Substrat dienenden Trägerband abgeschieden; sondern dieses Substratband wird zunächst mit wenigstens einer dünnen Zwischenschicht, die auch als Pufferschicht (bzw. "Buffer"-Schicht) bezeichnet wird, abgedeckt. Diese Pufferschicht mit einer Dicke in der Größenordnung von 1 μm soll einerseits das Eindiffundieren von Metallatomen aus dem Substrat in das HTS-Material verhindern, welche die supraleitenden Eigenschaften verschlechtern könnten. Zum anderen soll die Pufferschicht eine texturierte Ausbildung des HTS-Materials ermöglichen. Entsprechende Pufferschichten bestehen im Allgemeinen aus Oxiden von Metallen wie Zirkon, Cer, Yttrium, Aluminium, Strontium oder Magnesium oder Mischkristallen mit mehreren dieser Metalle und sind somit elektrisch isolierend. In einer entsprechenden stromleitenden Leiterbahn ergibt sich dadurch eine Problematik, sobald das supraleitende Material in den normalleitenden Zustand übergeht (sogenanntes "Quenchen"). Dabei wird der Supraleiter zunächst streckenweise resistiv und nimmt so einen Widerstand R an, z.B. indem er sich über die Sprungtemperatur $T_c$ seines Supraleitermaterial erwärmt (in sogenannten "Hot Spots" oder Teilquenchbereichen) und sich meist weiter erhitzt, so dass die Schicht durchbrennen kann.

Auf Grund dieser Problematik ist es bekannt, direkt auf der HTS-Leitungsschicht eine zusätzliche metallische Deckschicht aus einem elektrisch gut leitenden, mit dem HTS-Material verträglichen Material wie Au oder Ag als Shunt gegen ein Durchbrennen aufzubringen. Das HTS-Material steht also in einem elektrisch leitenden, flächenhaften Kontakt mit der metallischen Deckschicht (vgl. DE 44 34 819 C).

Bei der aus der eingangs genannten EP-A1-Schrift zu entnehmenden Strombegrenzereinrichtung wird ein anderer Typ eines bandförmigen Supraleiters verwendet. Hier ist die Leiterbahn aus einer supraleitenden Platte mit definierten Abmessungen gefertigt, indem seitliche Schlitze so eingearbeitet werden, dass eine Mäanderform entsteht. Da bei diesem Aufbau keine normalleitende Deckschicht vorgesehen ist, ist dort nach wie vor die Gefahr eines Durchbrennens im Bereich von Hot Spots gegeben.

Wegen der auch mit Shunts vorhandenen Hot-Spots oder Teilquenchbereiche verteilt sich die Spannung ungleichmäßig längs der Supraleiterschicht. In dem die supraleitende Schicht tragenden Substratband fällt hingegen die an den Enden angelegte Spannung U gleichmäßig über die gesamte Länge ab bzw. es befindet sich auf einem undefinierten Zwischenpotential, falls die Enden von der angelegten Spannung isoliert sind. Die Folge davon können unter Umständen Spannungsdifferenzen von der Leiterbahn über die Pufferschicht zum Substrat sein. Dies führt wegen der geringen Dicke dieser Schicht unvermeidlich zu elektrischen Durchschlägen und so zu punktueller Zerstörung der Pufferschicht und gegebenenfalls der Supraleitungsschicht. Für einen Durchschlag reichen typischerweise Spannungen in der Größenordnung von 20 bis 100 Volt für Pufferschichtdicken von 1 μm aus. Eine entsprechende Problematik ergibt sich insbesondere dann, wenn mit entsprechenden Leiterbändern resistive Strombegrenzereinrichtungen erstellt werden sollen. Bei einer solchen Einrichtung wird nämlich der Übergang vom supraleitenden in den normalleitenden Zustand zur Strombegrenzung im Kurzschlussfall ausgenutzt. Es ist hier nicht ohne weiteres möglich, die Pufferschicht ausreichend spannungsfest für die für solche Einrichtungen üblichen Betriebsspannungen im kV-Bereich zu machen.

Eine resistive supraleitende Strombegrenzungseinrichtung gemäß dem Oberbegriff des Anspruchs 1 ist aus WO 99/33122 bekannt.

Aufgabe der vorliegenden Erfindung ist es, bei einer resistiven supraleitenden Strombegrenzereinrichtung mit den eingangs genannten Merkmalen sowohl die Gefahr eines Durchbrennens im Bereich von Hot Spots zu verhindern als auch bei Verwendung von Pufferschichten einen elektrischen Durchschlag bei einem Quenchen im Strombegrenzungsfall auszuschließen.

Diese Aufgabe wird mit den in Anspruch 1 angegebenen Maßnahmen gelöst. Demgemäß soll die Strombegrenzereinrichtung mit den eingangs genannten Merkmalen einen Aufbau des bandförmigen Supraleiters aufweisen, der zumindest ein Substratband aus einem normalleitenden Substratmetall, eine supraleitende Schicht aus dem Hoch-$T_c$-Supraleitermaterial, wenigstens eine dazwischen angeordnete Pufferschicht aus einem isolierenden oxidischen Puffermaterial sowie eine auf der supraleitenden Schicht aufgebrachte Deckschicht aus einem normalleitenden Deckmetall enthält. Außerdem soll der Leiteraufbau mit wenigstens einem Kontaktierungselement aus einem normalleitenden Kontaktmetall zumindest an einer Längsseite des Aufbaus zwischen der Deckschicht und dem Substratband versehen sein, wobei für den normalleitenden Begrenzungszustand der Strombegrenzereinrichtung die Beziehung gelten soll:

$$R_K > 3 \cdot R_L$$

mit $R_L$ als dem elektrischen Widerstand des Leiteraufbaus ohne Kontaktierungselement über die Gesamtlänge der Leiterbahn und mit $R_K$ als dem Widerstand des wenigstens einen Kontaktierungselementes über die Gesamtlänge der Leiterbahn.

Dabei ist als Gesamtlänge die für den Schaltvorgang zwischen Supraleitung und Normalleitung der Strombegrenzereinrichtung zur Verfügung stehende Länge des bandförmigen Supraleiters zu verstehen. Der Widerstand $R_L$ setzt sich dabei aus einer Parallelschaltung des Widerstandes des Substratbandes, der Deckschicht sowie des maximal möglichen normalleitenden Widerstandes der supraleitenden Schicht zusammen. Werden mehrere Kontaktierungselemente vorgesehen, so bilden diese ebenfalls eine Parallelschaltung mit einem Gesamtwiderstand vom Wert $R_K$. Dieser Wert lässt sich in bekannter Weise durch die Materialwahl für das wenigstens eine Kontaktierungselement bzw. des elektrischen spezifischen Widerstandes $\rho$ seines Materials sowie durch die Dicke bzw. den zur Verfügung gestellten leitenden Querschnitts einstellen.

Die mit dieser Ausbildung der Strombegrenzereinrichtung verbundenen Vorteile sind insbesondere darin zu sehen, dass das metallische Substratband und die normalleitende Deckschicht und damit auch die mit ihr galvanisch verbundene supraleitende Schicht in Stromführungsrichtung gesehen zumindest in den Teilbereichen entlang der Länge des Aufbaus im gegenseitigen elektrischen Kontakt gebracht sind und somit auf einem einzigen elektrischen Potential auch im Falle eines Quenches liegen. Auf diese Weise wird ein Durchschlag über die Pufferschicht unterbunden.

Bei der vorgeschlagenen Strombegrenzereinrichtung können insbesondere noch folgende Maßnahmen im Einzelnen oder auch in Kombination zusätzlich vorgesehen werden:

- So kann für das Kontaktierungselement zumindest an einer Längsseite zwischen der Deckschicht und dem Substratband die Beziehung gelten: $\rho_K/d_K > 3 \cdot (d_s/\rho_s + d_6/\rho_6)^{-1}$ mit $\rho_K$, $\rho_6$ und $\rho_s$ dem spezifischen Widerstand des Materials des Kontaktierungselementes bzw. der Deckschicht bzw. des Substratbandes und $d_K$, $d_6$ und $d_s$ der Dicke des Materials des Kontaktierungselementes bzw. der Deckschicht bzw. des Substratbandes. Dabei wird von der Vorstellung ausgegangen, dass das Substratband den wesentlichen Beitrag zu dem Widerstand $R_L$ des Leiteraufbaus (ohne Kontaktierungselement) leistet. Dieser Widerstand muss im Allgemeinen hinreichend sein, um eine wirksame Strombegrenzung zu ermöglichen.

- Im Allgemeinen liegt die durchschnittliche Dicke des wenigstens einen Kontaktierungselementes unter 1 $\mu$m, vorzugsweise unter 0,5 $\mu$m. Vorteilhaft reichen nämlich für eine hinreichende galvanische Verbindung entsprechend dünne Schichten aus, da mit ihnen nur eine galvanische Verbindung, jedoch keine Führung größerer Ströme erfolgt.

- Als Material für das wenigstens eine Kontaktierungselement kann insbesondere Au oder Ag oder eine Legierung mit dem jeweiligen Element oder wenigstens einem weiteren Legierungspartner vorgesehen sein.

- Entsprechende Kontaktierungselemente können beispielsweise durch Lötverfahren an den Längsseiten des Leiteraufbaus angebracht oder mittels des Lotmaterials erzeugt sein. Da nur an den Seiten gelötet zu werden braucht, ist die Gefahr einer Schädigung des HTS-Materials entsprechend gering.

- Besonders vorteilhaft kann das Kontaktierungselement als ein den Leiteraufbau allseitig umschließendes Umhüllungselement ausgebildet sein.

- Ein solches Umhüllungselement kann als ein Geflecht oder eine Umwicklung oder eine Umspinnung oder ein Vlies ausgeführt sein.

- Stattdessen kann es auch als eine galvanische Beschichtung ausgebildet sein. Solche Beschichtungen sind, da nur eine geringe Dicke erforderlich ist, auf besonders einfache und für das HTS-Material schonende Weise zu erstellen.

Weitere vorteilhafte Ausgestaltungen der Strombegrenzereinrichtung nach der Erfindung gehen aus den vorstehend nicht angesprochenen Unteransprüchen hervor.

Zur weiteren Erläuterung der Erfindung wird nachfolgend auf die Zeichnung Bezug genommen, an Hand derer bevorzugte Ausführungsbeispiele von Strombegrenzereinrichtungen erläutert sind. Dabei zeigen jeweils in stark schematisierter Form

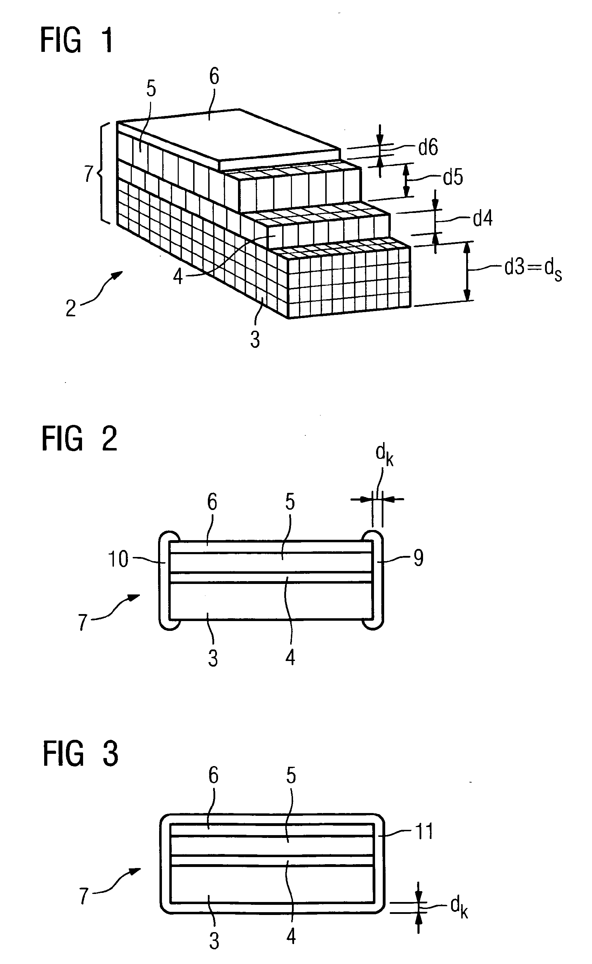

deren Figur 1 den Aufbau eines YBCO-Bandleiters der Strombegrenzereinrichtung in Schrägaufsicht,

deren Figur 2    diesen Bandleiter mit einer ersten Ausführungsform von Kontaktierungselementen in Querschnittsansicht

sowie

deren Figur 3    diesen Bandleiter mit einer anderen Ausführungsform eines Kontaktierungselementes in Querschnittsansicht.

Dabei sind in den Figuren sich entsprechende Teile jeweils mit denselben Bezugszeichen versehen.

Bei dem in Figur 1 angedeuteten, allgemein mit 2 bezeichneten Bandleiter wird von an sich bekannten Ausführungsformen von sogenannten YBCO-Bandleitern oder "YBCO Coated Conductors" ausgegangen. In der Figur sind bezeichnet mit

3 ein Substratband aus einem normalleitenden Substratmetall der Dicke d3 oder $d_S$,
4 wenigstens eine darauf aufgebrachte Pufferschicht aus einem isolierenden, oxidischen Puffermaterial der Dicke d4,
5 eine HTS-Schicht aus YBCO der Dicke d5,
6 eine Deckschicht aus einem normalleitenden Deckmetall der Dicke d6 als eine Schutz- und/oder Kontaktschicht, die auch aus mehreren Lagen bestehen kann, welche miteinander in innigem Kontakt stehen,

sowie

7 der Leiteraufbau aus diesen vier Teilen.

Selbstverständlich kann der Leiteraufbau auch noch weitere, an sich bekannte Schichten umfassen.

Dabei kann man die Teile des vorerwähnten Leiteraufbaus wie folgt ausbilden:

-    Ein metallisches Substratband 3 aus Ni, Ni-Legierungen oder Edelstahl mit einer Dicke d3 von etwa 20 bis 250 $\mu$m,
-    wenigstens eine Pufferschicht oder ein Pufferschichtensystem aus einer oder mehreren Lagen von Oxiden wie $CeO_2$ oder YSZ mit einer Dicke d4 von etwa 0,1 bis 1,5 $\mu$m,
-    wenigstens eine HTS-Schicht 5 aus YBCO mit einer Dicke d5 zwischen etwa 0,3 und 3 $\mu$m,

und

-    wenigstens eine metallische Deckschicht 6 aus Ag, Au oder Cu mit einer Dicke d6 zwischen etwa 0,1 $\mu$m und 1 mm. Gegebenenfalls kann die Deckschicht auch aus mehreren metallischen Lagen, insbesondere unter Stabilisierungs- und/oder Armierungsgesichtspunkten zusammengesetzt sein.

Ein entsprechender Bandleiter ist einige Millimeter bis wenige Zentimeter breit. Seine supraleitende Stromfähigkeit wird von der YBCO-Schicht 5, d.h. von deren kritischer Stromdichte bestimmt, während die thermischen, mechanischen und normalleitenden Eigenschaften wegen der größeren Dicke d3=$d_S$ von dem Substratband 3 und der Deckschicht 6 dominiert werden. Dabei bildet das Substratband zusammen mit der Pufferschicht eine Unterlage für ein quasi einkristallines Wachstum des YBCO. Substratbandmaterial und Pufferschichtmaterial dürfen im thermischen Ausdehnungskoeffizienten und in ihren kristallographischen Gitterkonstanten nicht zu weit vom YBCO abweichen. Je besser die Anpassung desto höher ist die rissfreie Schichtdicke und desto besser die Kristallinität des YBCO. Darüber hinaus ist für hohe kritische Stromdichten im MA/cm$^2$-Bereich eine möglichst parallele Ausrichtung der Kristallachsen in benachbarten Kristalliten gewünscht. Dies erfordert eine eben solche Ausrichtung zumindest in der obersten Pufferschicht, damit das YBCO heteroepitaktisch aufwachsen kann. Die Präparation solcher quasi einkristalliner flexibler Substrat-Puffersysteme gelingt bevorzugt mit drei Verfahren:

-    Sogenanntes "Ion Beam Assisted Deposition (IBAD)" von meist YSZ oder MgO auf untexturierten Metallbändern,
-    sogenannte "Inclined Substrate Deposition (ISD)" von YSZ oder MgO auf untexturierten Metallbändern,
-    sogenannte "Rolling Assisted Biaxially Textured Substrates (RABiTS)", d.h. durch Walz- und Glühbehandlung in Würfellage gebrachte Substrate mit heteroepitaktischem Puffersystem.

Die auf dem Substratband abzuscheidenden Funktionsschichten 4 bis 6 werden in an sich bekannter Weise mit Vakummbeschichtungsverfahren (PVD), chemischer Abscheidung aus der Gasphase (CVD) oder aus chemischen Lösungen (CSD) hergestellt.

Selbstverständlich können zwischen den einzelnen Schichten des Aufbaus 7 noch vergleichsweise dünnere, sich bei der Herstellung des Aufbaus bzw. der Abscheidung der einzelnen Schichten insbesondere durch Diffusions- und/oder Reaktionsvorgänge ausbildende Zwischenschichten vorhanden sein.

Im Vergleich zu den für YBCO-Dünnschicht-Strombegrenzer bekannten keramischen Plattenleitern ist bei Bandleitern des vorstehend geschilderten Typs das Substratband 3 elektrisch leitfähig, d.h. es kann den begrenzten Strom tragen und als Shunt wirken. Mit dem in der Figur gezeigten Leiteraufbau 7 wären jedoch die HTS-Schicht 5 und das Substratband 3 voneinander isoliert. Sobald die Strombegrenzungseinrichtung in ihren begrenzenden Zustand übergeht, d.h. normalleitend wird und sich eine Spannung längs der Leiterbahn aufbaut, wird die Durchschlagsfeldstärke der bekannten Pufferschichtmaterialien, die in der Größenordnung von 100 kV/mm = 10 V/0,1 $\mu$m liegen, schnell überschritten. D.h., die Pufferschicht 4 würde dann unkontrolliert durchschlagen. Daher ist erfindungsgemäß ein guter elektrischer Kontakt zwischen der Supraleitungsschicht 5 und dem metallischen Substratband 3 bevorzugt auf der ganzen Leiterlänge für den Einsatz von Bandleitern in Strombegrenzern vorteilhaft.

Eine entsprechende durchgängige Kontaktierung über die ganze Länge lässt sich aus der Ausführungsform nach Figur 2 ersehen. Dort ist der in Figur 1 gezeigte Leiteraufbau 7 an wenigstens einer Längsseite mit einem Kontaktierungselement 9 und/oder 10 versehen. Dieses Kontaktierungselement besteht aus einem elektrisch gut leitenden Material wie aus Au, Ag oder Cu oder einer Legierung mit dem jeweiligen Element. Es hat die Aufgabe, eine galvanische Verbindung zwischen der supraleitenden Schicht 5 und der elektrisch mit ihr verbundenen normalleitenden Deckschicht 6 einerseits und dem unteren normalleitenden Substratband 3 andererseits an der jeweiligen Längsseite bzw. -kante zu gewährleisten. Auf diese Weise liegen diese Teile bei jedem Betriebszustand der Strombegrenzereinrichtung wegen der gegenseitigen galvanischen Verbindung auf demselben elektrischen Potential.

Vorteilhaft wird der Materialquerschnitt der Kontaktierungselemente so bemessen, dass sie praktisch nicht als elektrischer Shunt für den begrenzten Strom wirken. Dies ist durch die Materialwahl und/oder die mittlere Dicke der Kontaktierungselemente zu gewährleisten. Für die Bemessungsregel gilt:

$$R_K > 3 \cdot R_L, \text{ vorzugsweise } R_K > 10 \cdot R_L.$$

Dabei ist $R_L$ der elektrische Widerstand des gesamten Leiteraufbaus 7 ohne Kontaktierungselement 9, 10, gemessen über die gesamte Länge der Leiterbahn. Der Widerstand $R_L$ setzt sich dabei aus einer Parallelschaltung des Widerstandes des Substratbandes 3, der Deckschicht 6 sowie des maximal möglichen Widerstandes der supraleitenden Schicht 5 im Falle deren Normalleitung zusammen. $R_K$ ist Widerstand aller parallel geschalteten Kontaktierungselemente 9, 10 über die diese Gesamtlänge.

Der Wert $R_K$ lässt sich in bekannter Weise durch die Materialwahl für das wenigstens eine Kontaktierungselement bzw. des elektrischen spezifischen Widerstandes $\rho_K$ seines Materials sowie durch die Dicke $d_K$ bzw. den zur Verfügung gestellten elektrisch leitenden Querschnitts einstellen. Allgemein sollte dabei gelten:

$$\rho_K/d_K > 3 \cdot (d_s/\rho_S + d_6/\rho_6)^{-1}.$$

Dabei sind $\rho_K$, $\rho_6$ und $\rho_S$ der spezifische Widerstand des Materials des Kontaktierungselementes 9 und 10 bzw. der Deckschicht 6 bzw. des Substratbandes 3 und $d_K$, $d_6$ und $d_s$ die gesamte mittlere Dicke des Materials aller Kontaktierungselemente bzw. der Deckschicht 6 bzw. des Substratbandes. Vorteilhaft werden noch höhere Werte für $\rho_K/d_K$ gewählt, so dass diese Größe mindestens fünfmal, vorzugsweise mindestens zehnmal so groß wie $\rho_s/d_s$ und $\rho_6/d_6$ ist.

Unter Berücksichtigung der vorerwähnten Beziehungen liegt dann die Dicke $d_K$ im Allgemeinen unter 1 $\mu$m, vorzugsweise unter 0,5 $\mu$m.

Bevorzugt sind entsprechende Kontaktierungselemente 9 und 10 mittels Lötverfahren an den Seiten des Leiteraufbaus 7 anzubringen. Dabei kann selbstverständlich das jeweilige Kontaktierungselement 9 oder 10 auch ein Stück weit die obere Flachseite der Deckschicht 6 und/oder die untere Flachseite des Substratbandes 3 mit abdecken, wie in Figur 2 angedeutet ist.

Gemäß Figur 3 ist es auch möglich und besonders vorteilhaft, wenn die Kontaktierungselemente als den Leiteraufbau 7 allseitig umschließendes Umhüllungselement 11 ausgebildet sind. Ein entsprechendes Umhüllungselement kann beispielsweise aus einem normalleitenden Drahtgeflecht oder einer Drahtumwicklung oder aus einer Drahtumspinnung oder als ein Drahtvlies erstellt sein. Statt Drähten können selbstverständlich für diesen Zweck auch Bänder vorgesehen werden. Besonders vorteilhaft lässt sich ein umhüllendes Kontaktierungselement 11 auch mittels eines galvanischen Beschichtungsvorgangs erstellen. Entsprechende Schichten mit der geringen Dicke $d_K$ in der vorerwähnten Größenordnung sind auf einfache Weise und insbesondere ohne Beeinträchtigung der supraleitenden Eigenschaften der supraleitenden Schicht 5 auszubilden.

Bei den vorstehenden Ausführungsbeispielen wurde YBCO als HTS-Material für die supraleitende Schicht 5 zugrunde gelegt. Selbstverständlich sind auch andere HTS-Materialien vom sogenannten 1-2-3-Typ mit anderen Seltenen Erdmetallen und/oder anderen Erdalkalimetallen einsetzbar. Die einzelnen Komponenten dieser Materialien können auch in an sich bekannter Weise teilweise durch weitere/andere Komponenten substituiert sein.

**Patentansprüche**

1. Resistive supraleitende Strombegrenzereinrichtung, deren Leiterbahn (2) mit einem bandförmigen Supraleiter gebildet ist, dessen oxidisches Hoch-$T_c$-Supraleitermaterial vom Typ $AB_2Cu_3O_x$ ist, wobei A mindestens ein Seltenes Erdmetall einschließlich Yttrium und B mindestens ein Erdalkalimetall sind, wobei der Aufbau (7) des bandförmigen Supraleiters zumindest

   - ein Substratband (3) aus einem normalleitenden Substratmetall,
   - eine supraleitende Schicht (5) aus dem Hoch-$T_c$-Supraleitermaterial,
   - wenigstens eine dazwischen angeordnete Pufferschicht (4) aus einem isolierenden oxidischen Puffermaterial

   sowie

   - eine auf der supraleitenden Schicht (5) aufgebrachte Deckschicht (6) aus einem normalleitenden Deckmetall

   enthält und mit wenigstens einem Kontaktierungselement (9, 10, 11) aus einem normalleitenden Kontaktierungsmaterial zumindest an einer Längsseite des Aufbaus (7) zwischen der Deckschicht (6) und dem Substratband (3) versehen ist, **dadurch gekennzeichnet, dass** für den normalleitenden Begrenzungszustand der Strombegrenzereinrichtung die Beziehung gilt:

$$R_K > 3 \cdot R_L$$

   mit $R_L$ als dem elektrischen Widerstand des Aufbaus (7) ohne Kontaktierungselement über die Gesamtlänge der Leiterbahn (2) und mit $R_K$ als dem Widerstand des wenigstens einen Kontaktierungselementes (9, 10, 11) über die Gesamtlänge.

2. Strombegrenzereinrichtung nach Anspruch 1, **dadurch gekennzeichnet, dass** für das wenigstens eine Kontaktierungselement (9, 10) zumindest an einer Längsseite zwischen der Deckschicht (6) und dem Substratband (3) die Beziehung gilt:

$$\rho_K/d_K > 3 \cdot (d_s/\rho_S + d_6/\rho_6)^{-1}$$

   mit $\rho_K$, $\rho_6$ und $\rho_s$ dem spezifischen Widerstand des Materials des wenigstens einen Kontaktierungselementes bzw. der Deckschicht bzw. des Substratbandes und $d_K$, $d_6$ und $d_s$ der Dicke des Materials des wenigstens einen Kontaktierungselementes bzw. der Deckschicht bzw. des Substratbandes.

3. Strombegrenzereinrichtung nach Anspruch 1 oder 2, **dadurch gekennzeichnet, dass** die Beziehung gilt:

$$R_K > 10 \cdot R_L .$$

4. Strombegrenzereinrichtung nach Anspruch 2, **dadurch gekennzeichnet, dass** die Beziehung gilt:

$$\rho_K/d_K > 10 \cdot (d_s/\rho_S + d_6/\rho_6)^{-1}.$$

5. Strombegrenzereinrichtung nach einem vorangehenden Ansprüche, **dadurch gekennzeichnet, dass** die durchschnittliche Dicke ($d_K$) des wenigstens einen Kontaktierungselementes (9, 10, 11) unter 1 μm, vorzugsweise unter 0,5 μm liegt.

6. Strombegrenzereinrichtung nach einem der vorangehenden Ansprüche, **dadurch gekennzeichnet, dass** als Material des wenigstens einen Kontaktierungselementes (9 bis 11) Au oder Ag oder Cu oder eine Legierung mit dem jeweiligen Element vorgesehen ist.

7. Strombegrenzereinrichtung nach einem der vorangehenden Ansprüche, **gekennzeichnet durch** wenigstens ein mittels Lötverfahrens angebrachtes oder erzeugtes Kontaktierungselement (9, 10, 11).

8. Strombegrenzereinrichtung nach einem der vorangehenden Ansprüche, **dadurch gekennzeichnet, dass** das Kontaktierungselement als ein den Leiteraufbau (7) allseitig umschließendes Umhüllungselement (11) ausgebildet ist.

9. Strombegrenzereinrichtung nach Anspruch 8, **gekennzeichnet durch** ein Geflecht oder eine Umwicklung oder eine Umspinnung oder ein Vlies als Umhüllungselement (11).

10. Strombegrenzereinrichtung nach Anspruch 8, **gekennzeichnet durch** eine galvanische Beschichtung als Umhüllungselement (11).

11. Strombegrenzereinrichtung nach einem der vorangehenden Ansprüche, **dadurch gekennzeichnet, dass** die Deckschicht (6) aus mehreren metallischen Lagen zusammengesetzt ist.

## Claims

1. Resistive superconducting current-limiter device, whose conductor track (2) is formed by a superconductor in the form of a strip, whose oxidic high-$T_c$ superconductor material is of the $AB_2Cu_3O_x$ type, with A being at least one rare earth metal including yttrium, and B being at least one alkaline earth metal, in which the structure (7) of the superconductor which is in the form of a strip at least contains

   - a substrate strip (3) composed of a normally conductive substrate metal,
   - a superconducting layer (5) composed of the high-$T_C$ superconductor material,
   - at least one buffer layer (4), which is arranged in between them and is composed of an insulating oxidic buffer material
   and
   - a covering layer (6) which is applied to the superconducting layer (5) and is composed of a normally conductive covering metal,
   - and is provided with at least one contact-making element (9, 10, 11) composed of a normally conductive contact material, at least on one longitudinal side of the structure (7) between the covering layer (6) and the substrate strip (3), **characterized in that** the following relationship applies to the normally conductive limiting state of the current-limiter device:

$$R_k > 3 \cdot R_L,$$

   where $R_L$ is the electrical resistance of the structure (7) without the contact-making element over the entire length of the conductor track (2), and $R_K$ is the resistance of the at least one contact-making element (9, 10, 11) over the entire length of the conductor track.

2. The current-limiter device according to claim 1, **characterized in that** the relationship for the at least one contact-making element (9, 10), at least on one longitudinal side between the covering layer (6) and the substrate strip (3) is:

$$\rho_k/d_k > 3 \cdot (d_s/\rho_s + d_6/\rho_6)^{-1}$$

where $\rho_k$, $\rho_6$ and $\rho_S$ are respectively the resistivities of the material of the at least one contact-making element, of the covering layer and of the substrate strip, and $d_k$, $d_6$ and $d_s$ are respectively the thickness of the material of the at least one contact-making element, of the covering layer and of the substrate strip.

3. The current-limiter device according to claim 1 or 2, **characterized in that** the relationship is:

$$R_K \; > \; 10 \; \cdot \; R_L.$$

4. The current-limiter device according to claim 2, **characterized in that** the relationship is:

$$\rho_K/d_k \; > \; 10 \; \cdot \; (d_S/\rho_S \; + \; d_6/\rho_6)^{-1}.$$

5. The current-limiter device according to one of the preceding claims, **characterized in that** the average thickness ($d_K$) of the at least one contact-making element (9, 10, 11) is less than 1 $\mu$m, preferably less than 0.5 $\mu$m.

6. The current-limiter device according to one of the preceding claims, **characterized in that** gold, silver, copper or an alloy with the respective element is provided as the material for the at least one contact-making element (9 to 11).

7. The current-limiter device according to one of the preceding claims, **characterized by** at least one contact-making element (9, 10, 11) which is applied or produced by means of a soldering process.

8. The current-limiter device according to one of the preceding claims, **characterized in that** the contact-making element is in the form of a sheathing element (11) which surrounds the conductor structure (7) on all sides.

9. The current-limiter device according to claim 8, **characterized by** a mesh, a surrounding winding or surrounding spinning, or a non-woven as the sheathing element (11).

10. The current-limiter device according to claim 8, **characterized by** an electrochemical coating as the sheathing element (11).

11. The current-limiter device according to one of the preceding claims, **characterized in that** the covering layer (6) is composed of a plurality of metallic layers.

**Revendications**

1. Dispositif résistif supraconducteur de limitation du courant, dont la piste (2) conductrice est formée d'un supraconducteur en forme de ruban, dont le matériau supraconducteur oxydé à $T_c$ haute est du type $AB_2Cu_3O_x$, A étant au moins un métal de terres rares y compris l'yttrium et B au moins un métal alcalino-terreux, la structure (7) de supraconducteur en forme de ruban comportant au moins

    - un ruban (3) de substrat en un métal de substrat normalement conducteur,
    - une couche (5) supraconductrice en le matériau supraconducteur à $T_c$ haute,
    - au moins une couche (4) tampon en un matériau tampon oxydé isolant interposée entre eux ainsi que
    - une couche (6) de finition en un métal de finition normalement conducteur, déposée sur la couche (5) supraconductrice et munie au moins d'un élément (9, 10, 11) de mise en contact en un matériau de mise en contact normalement conducteur, au moins sur un grand côté de la structure (7) entre la couche (6) de finition et le ruban (3) de substrat, **caractérisé en ce que** pour l'état de limitation normalement conducteur du dispositif de limitation du courant, on a la relation :

$$R_K \; > \; 3 \; \cdot \; R_L$$

R étant la résistance électrique de la structure (7) sans élément de mise en contact sur toute la longueur de la piste (2) conductrice et $R_K$ étant la résistance du au moins un élément (9, 10, 11) de contact sur toute la longueur.

2. Dispositif de limitation du courant suivant la revendication 1, **caractérisé en ce que**, pour le au moins un élément (9, 10) de mise en contact, on a au moins la relation, au moins sur un grand côté entre la couche (6) de finition et le ruban (3) de substrat :

$$\rho_K/d_K > 3 \cdot (d_S/\rho_S + d_6/\rho_6)^{-1}$$

$\rho_K$, $\rho_6$ et $\rho_S$ étant la résistance spécifique du matériau du au moins un élément de mise en contact et de la couche de finition et du ruban de substrat, respectivement, et $d_K$, $d_6$ et $d_s$ étant l'épaisseur du matériau au au moins un élément de mise en contact et de la couche de finition et du ruban de substrat, respectivement.

3. Dispositif de limitation du courant suivant la revendication 1 ou 2, **caractérisé en ce que** l'on a la relation :

$$R_K > 10 \cdot R_L.$$

4. Dispositif de limitation du courant suivant la revendication 2, **caractérisé en ce que** l'on a la relation :

$$\rho_K/d_K > 10 \cdot (d_S/\rho_S + d_6/\rho_6)^{-1}.$$

5. Dispositif de limitation du courant suivant l'une des revendications précédentes, **caractérisé en ce que** l'épaisseur ($d_K$) moyenne du au moins un élément (9, 10, 11) de mise en contact est plus petite que 1 $\mu$m, de préférence plus petite que 0,5 $\mu$m.

6. Dispositif de limitation du courant suivant l'une des revendications précédentes, **caractérisé en ce que**, comme matériau du au moins un élément (9 à 11) de mise en contact, il est prévu Au ou Ag ou Cu ou un alliage de l'élément respectif.

7. Dispositif de limitation du courant suivant l'une des revendications précédentes, **caractérisé par** au moins un élément (9, 10, 11) de mise en contact à poser ou produit au moyen d'un procédé de brasage.

8. Dispositif de limitation du courant suivant l'une des revendications précédentes, **caractérisé en ce que** l'élément de mise en contact est constitué sous la forme d'un élément (11) d'enveloppe entourant de tous côtés la structure (7) conductrice.

9. Dispositif de limitation du courant suivant la revendication 8, **caractérisé par** un treillis ou un gainage ou un guipage ou un non tissé comme élément (11) d'enveloppe.

10. Dispositif de limitation du courant suivant la revendication 8, **caractérisé par** un revêtement galvanique comme élément (11) d'enveloppe.

11. Dispositif de limitation du courant suivant l'une des revendications précédentes, **caractérisé en ce que** la couche (6) de finition est composée de plusieurs strates métalliques.

FIG 1

FIG 2

FIG 3

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 0523374 A1
- EP 0292959 A1
- DE 4434819 C
- WO 9933122 A